(19) Europäisches Patentamt / European Patent Office / Office européen des brevets

(11) **EP 2 993 481 A1**

(12) **EUROPEAN PATENT APPLICATION**
published in accordance with Art. 153(4) EPC

(43) Date of publication:
**09.03.2016 Bulletin 2016/10**

(21) Application number: **13883512.9**

(22) Date of filing: **23.08.2013**

(51) Int Cl.:
**G01R 29/10** (2006.01)

(86) International application number:
**PCT/CN2013/082194**

(87) International publication number:
**WO 2014/176846 (06.11.2014 Gazette 2014/45)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **02.05.2013 CN 201310158536**

(71) Applicant: **Huizhou TCL Mobile Communication Co., Ltd.**
**Huizhou, Guangdong 516006 (CN)**

(72) Inventor: **BAI, Jian**
**HuiZhou, Guangdong 516006 (CN)**

(74) Representative: **Petraz, Gilberto Luigi et al**
**GLP S.r.l.**
**Viale Europa Unita, 171**
**33100 Udine (IT)**

(54) **FAST TEST METHOD FOR TOTAL RADIATION POWER OF TERMINAL ANTENNA**

(57) A method for quickly testing a total radiated power of an antenna of a terminal is provided, comprising: looking up a first antenna polarization direction corresponding to a Θ angle and a Φ angle which conform with a prescribed requirement according to a transmission power intensity and direction pattern; testing equivalent radiated power of channels to be tested; integral calculating all the equivalent radiated powers to obtain a total radiated power of the antenna of the terminal. In this method, the production process of the equivalent radiated power at the Θ angle and Φ angle is simplified, thereby increasing the testing efficiency of the total radiated power.

EP 2 993 481 A1

**Description**

FIELD OF THE INVENTION

The present invention relates to a mobile communication terminal, and more particularly to a method for quickly testing a total radiated power of an antenna of a terminal.

BACKGROUND OF THE INVENTION

Nowadays, in the radio frequency performance test of wireless terminals (such as mobile phones), the test of the radio frequency performance of a whole terminal has been more and more concerned. The radio frequency performance reflects performances of transmitting and receiving of the mobile phones. In the prior art, there are two methods for testing the radio frequency performance of the mobile phones. One of the methods is determining the radio frequency performance of an antenna, and it is a conventional antenna testing method, which is called a passive test. The other method is testing the radiated power and receiving sensitivity of a mobile phone in a particular microwave anechoic chamber, which is called an active test. An OTA (Over the Air) test belongs to the active test. In the prior art, the basic working process of testing the radiated performance of the antenna by an OTA test system is as follows:

1. A terminal is disposed upon a rotary table in the anechoic chamber, and is connected with a base station emulator by an antenna. Signals emitted from the base station emulator are transmitted to the terminal by a chamber measuring antenna. The emitted signals are received and decoded by a receiving system of the terminal.
2. The terminal on the rotary table is moved to different rotary table Θ (Theta) angles and Φ (Phi) angles sequentially, and a polarization direction of the measuring antenna to be tested is correspondingly adjusted in each angle. In each Θ angle and Φ angle, the polarization positions of the measuring antenna should be adjusted twice (i.e. horizontal and perpendicular polarization directions). Normally, in test system of the antenna of the terminal, the Θ angle of the rotary table should be tested from 0 to 180 degrees, and each 30 degrees is one step, and there are 6 steps. The Φ angle should be tested from 0 to 360 degrees, and each 30 degrees is one step, and there are 12 steps. In addition, in the OTA chamber, the horizontal and perpendicular polarization directions of the measuring antenna are utilized, so that the total test points are 6x12x2=144.
3. At each test point, power transmitted from the terminal is measured by the base station emulator or a spectrum analyzer of the test system, and the measured power is ERP (Effective Radiated Power). The power of each channel to be tested will be tested for each test point, so that the test time of each test point is: $T = T_{power}x$ $N_{the\ number\ of\ total\ channels\ to\ be\ tested} + T_{time\ of\ changing\ channels} \times (N_{the\ number\ of\ total\ channels\ to\ be\ tested}-1)$.
4. After obtaining the ERP of each test point, the ERP is compensated with a path loss of the chamber (at a fixed frequency point and in one antenna polarization direction in the chamber, the path loss is a fixed offset value), and integral calculation is executed to obtain a final antenna TRP (Total Radiated Power). The

$$\text{formula is as follows:}\quad TRP \cong \frac{\pi}{2NM} \sum_{i=0}^{N-1} \sum_{j=0}^{M-1} [ERP_\theta(\theta_i,\varphi_j) + ERP_\varphi(\theta_i,\varphi_j)]\sin(\theta_i)$$

Where N is the number of test points of the rotary table Theta (Θ) angle, per 30° is one step, and N=6. M is the number of test points of the rotary table Phi (Φ) angle, per 30° is one step, and M=12.

Obviously, the calculation in testing the TRP of terminals by the conventional OTA test system is complicated, and a long testing time is needed, thereby increasing testing costs.

Therefore, the prior art needs to be improved and developed.

SUMMARY OF THE INVENTION

In view of the deficiencies of the prior art as described above, in order to overcome the defects and deficiencies of the prior art, the present invention provides a method for quickly testing a TRP of an antenna, which takes less time to test the radiated performance of the antenna of the terminal by an OTA test system, so that the testing efficiency is improved.

The present invention adopts the following technical solutions for solving the technical problems.

A method for quickly testing a total radiated power of an antenna of a terminal comprises: looking up a first antenna polarization direction from a pre-stored transmission power intensity and direction pattern, where the first antenna polarization direction corresponds to a Θ angle and a Φ angle which conform with a prescribed requirement; rotating a rotary table to a direction corresponding to the first antenna polarization direction; measuring equivalent radiated powers of all channels to be tested in the first antenna polarization direction; compensating the equivalent radiated power with a path loss of a chamber, thereby obtaining $ERP_{best,CHi}$; calculating $ERP_{CHi}$ according to a formula $ERP_{CHi} = ERP + (ERP_{best,CHi} - ERP_{best})$, where $ERP_{CHi}$ is the equivalent radiated power of each channel to be tested, $ERP_{best}$ is a transmitted power at a test point which conforms with the prescribed requirement in the transmission power intensity and direction pattern, the ERP is an equivalent radiated power of the channel to be tested in a current antenna polarization direction; and integral calculating and obtaining $TRP_{CHi}$ according to a formula $TRP_{CHi}$

$$\cong \frac{\pi}{2NM} \sum_{i=0}^{N-1} \sum_{j=0}^{M-1} [ERP_{\theta,CH_i}(\theta_i, \varphi_j) + ERP_{\varphi,CH_i}(\theta_i, \varphi_j)] \sin(\theta_i),$$ where N is the number of test points corresponding to the Θ angle, M is the number of test points corresponding to the Φ angle, and i and j are integer numbers; where a working channel is set at a middle value of all channels to be tested, the antenna polarization direction comprises a horizontal polarization direction and a perpendicular polarization direction.

The above-mentioned method for quickly testing the total radiated power of the antenna of the terminal further comprises: composing the equivalent radiated powers of all test points into the transmission power intensity and direction pattern and storing the same, where each Θ angle and each Φ angle corresponding to the antenna polarization direction is served as one of the test points.

In the above-mentioned method for quickly testing the total radiated power of the antenna of the terminal further comprises: rotating the terminal either to the Θ angle or the Φ angle by rotating the rotary table; testing the equivalent radiated power at each of the test points, where the equivalent radiated power of the test point corresponds to power of the test point in one channel, and a rotation to either the Θ angle or the Φ angle corresponds to a variation of the antenna polarization direction.

In the above-mentioned method for quickly testing the total radiated power of the antenna of the terminal further comprises: transmitting a signal emitted from a base station emulator to the terminal by a measuring antenna in the chamber, where the terminal is disposed upon the rotary table in the chamber, and the terminal is connected with the base station emulator by the antenna; and setting any one of the channels to be tested as the working channel of the base station emulator.

The above-mentioned method for quickly testing the total radiated power of the antenna of the terminal further comprises: sampling and testing the equivalent radiated power of the test point according to the transmission power intensity and direction pattern; and correcting the transmission power intensity and direction pattern by using a difference value from an original equivalent radiated power.

In the above-mentioned method for quickly testing the total radiated power of the antenna of the terminal further comprises: finding a test point with a best equivalent radiated power $ERP_{ori}$ for each Θ angle; looking up a Φ angle and an antenna polarization direction corresponding to the $ERP_{ori}$, and then rotating to the corresponding antenna polarization direction; testing an equivalent radiated power $ERP_{new}$; calculating the difference value between the $ERP_{new}$ and the $ERP_{ori}$ by a formula offset = $ERP_{new}$ - $ERP_{ori}$; re-correcting the equivalent radiated power by a correction formula $ERP_{new,phi,polar} = ERP_{ori,phi,polar}$ + offset, thereby obtaining the optimized equivalent radiated power $ERP_{new,phi,polar}$ of the test point, where $ERP_{ori,phi,polar}$ represents the original equivalent radiated power in the antenna polarization direction corresponding to the Θ angle and the Φ angle in the transmission power intensity and direction pattern; correcting the transmission power intensity and direction pattern by repeating above steps for other Θ angles.

In the above-mentioned method for quickly testing the total radiated power of the antenna of the terminal, a range of the Θ angle is between 0 and 180 degrees, each 30 degrees is one step, and there are 6 steps.

In the above-mentioned method for quickly testing the total radiated power of the antenna of the terminal, a range of the Φ angle is between 0 and 360 degrees, each 30 degrees is one step, and there are 12 steps.

A method for quickly testing a total radiated power of an antenna of a terminal comprises: looking up a first antenna polarization direction from a pre-stored transmission power intensity and direction pattern, where the first antenna polarization direction corresponds to a Θ angle and a Φ angle which conform with a prescribed requirement; rotating a rotary table to a direction corresponding to the first antenna polarization direction; measuring equivalent radiated powers of all channels to be tested in the first antenna polarization direction; compensating the equivalent radiated power with a path loss of a chamber, thereby obtaining $ERP_{best,CHi}$; calculating $ERP_{CHi}$ according to a formula $ERP_{CHi} = ERP + (ERP_{best,CHi}-ERP_{best})$, where $ERP_{CHi}$ is the equivalent radiated power of each channel to be tested, $ERP_{best}$ is a transmitted power at a test point which conforms with the prescribed requirement in the transmission power intensity and direction pattern, the ERP is an equivalent radiated power of the channel to be tested in a current antenna polarization direction; and integral calculating and obtaining $TRP_{CHi}$ according to a formula $TRP_{CHi}$

$$\cong \frac{\pi}{2NM} \sum_{i=0}^{N-1} \sum_{j=0}^{M-1} [ERP_{\theta,CH_i}(\theta_i,\varphi_j) + ERP_{\varphi,CH_i}(\theta_i,\varphi_j)]\sin(\theta_i),$$ where N is the number of test points

corresponding to the $\Theta$ angle, M is the number of test points corresponding to the $\Phi$ angle, i and j are integer numbers.

In the above-mentioned method for quickly testing the total radiated power of the antenna of the terminal further comprises: composing the equivalent radiated powers of all test points into the transmission power intensity and direction pattern and storing the same, where each $\Theta$ angle and each $\Phi$ angle corresponding to the antenna polarization direction is served as one of the test points.

The above-mentioned method for quickly testing the total radiated power of the antenna of the terminal further comprises: rotating the terminal either to the $\Theta$ angle or the $\Phi$ angle by rotating the rotary table; and testing the equivalent radiated power at each of the test points, where the equivalent radiated power of the test point corresponds to power of the test point in one channel, and a rotation to either the $\Theta$ angle or the $\Phi$ angle corresponds to a variation of the antenna polarization direction.

The above-mentioned method for quickly testing the total radiated power of the antenna of the terminal further comprises: transmitting a signal emitted from a base station emulator to the terminal by a measuring antenna in the chamber, where the terminal is disposed upon the rotary table in the chamber, and the terminal is connected with the base station emulator by the antenna; and setting any one of the channels to be tested as the working channel of the base station emulator.

The above-mentioned method for quickly testing the total radiated power of the antenna of the terminal, a working channel is set at a middle value of all channels to be tested.

The above-mentioned method for quickly testing the total radiated power of the antenna of the terminal, the antenna polarization direction comprises a horizontal polarization direction and a perpendicular polarization direction.

The above-mentioned method for quickly testing the total radiated power of the antenna of the terminal further comprises: sampling and testing the equivalent radiated power of the test point according to the transmission power intensity and direction pattern; and correcting the transmission power intensity and direction pattern by using a difference value from an original equivalent radiated power.

The above-mentioned method for quickly testing the total radiated power of the antenna of the terminal further comprises: finding a test point with a best equivalent radiated power $ERP_{ori}$ for each $\Theta$ angle; looking up a $\Phi$ angle and an antenna polarization direction corresponding to the $ERP_{ori}$, and then rotating to the corresponding antenna polarization direction; testing an equivalent radiated power $ERP_{new}$; calculating the difference value between the $ERP_{new}$ and the $ERP_{ori}$ by a formula offset = $ERP_{new}$ - $ERP_{ori}$; re-correcting the equivalent radiated power by a correction formula $ERP_{new,phi,polar} = ERP_{ori,phi,polar}$ + offset, thereby obtaining the optimized equivalent radiated power $ERP_{new,phi,polar}$ of the test point, where $ERP_{ori,phi,polar}$ represents the original equivalent radiated power in the antenna polarization direction corresponding to the $\Theta$ angle and the $\Phi$ angle in the transmission power intensity and direction pattern; and correcting the transmission power intensity and direction pattern by repeating above steps for other $\Theta$ angles.

In the above-mentioned method for quickly testing the total radiated power of the antenna of the terminal, a range of the $\Theta$ angle is between 0 and 180 degrees, each 30 degrees is one step, and there are 6 steps.

In the above-mentioned method for quickly testing the total radiated power of the antenna of the terminal, a range of the $\Phi$ angle is between 0 and 360 degrees, each 30 degrees is one step, and there are 12 steps.

In comparison with the prior art, in the method of the present invention, the production process of the equivalent radiated power in two kinds of the antenna polarization directions at the $\Theta$ angle and $\Phi$ angle of each rotary table is simplified. In the meanwhile, the original transmission power intensity and direction pattern is corrected by sampling a few of the ERP of the test points, thereby obtaining a new transmission power intensity and direction pattern. The correction makes the testing result more accurate. Also, the testing efficiency of the total radiated power is increased due to the simplified calculation method, and the testing cost is therefore decreased.

## DETAILED DESCRIPTION OF THE INVENTION

In order to make the objectives, technical solutions, and advantages of the present invention clearer, the present invention will be further described below with reference to the attached drawings and embodiments thereof. It should be understood that the embodiments described herein are only intended to illustrate but not to limit the present invention.

A method for quickly testing a total radiated power of an antenna of a terminal and for testing a radiated performance of the antenna of the terminal in an OTA chamber comprises the following steps:

S10, a terminal is disposed upon a rotary table in a chamber, and is connected with a base station emulator by an antenna. Signals emitted from the base station emulator are transmitted to the terminal by a measuring antenna. The signals emitted from the base station emulator are received and decoded by a receiving system of the terminal. Any one of the channels to be tested is set as the working channel of the base station emulator. It should be noted that, preferably, the working channel is set at a middle value of all channels to be tested.

S20, the terminal is rotated to different rotary table $\Theta$ angles and $\Phi$ angles sequentially, and an antenna polarization direction is correspondingly adjusted in each $\Theta$ angle and $\Phi$ angle. Each $\Theta$ angle and each $\Phi$ angle corresponding to the antenna polarization direction is served as one test point. The power at each channel of each test point is tested for obtaining ERP at the corresponding test point. The antenna polarization direction comprises a horizontal polarization direction and a perpendicular polarization direction. The $\Theta$ angle of the rotary table is from 0 to 180 degrees, each 30 degrees is one step, and there are 6 steps. The $\Phi$ angle is from 0 to 360 degrees, each 30 degrees is one step, and there are 12 steps. In this step, the terminal on the rotary table is rotated to different $\Theta$ angles and $\Phi$ angles, and each rotation is based on a respective step. The antenna polarization direction is adjusted in each angle. That is, the polarization position of the antenna should be adjusted twice in each $\Theta$ angle and $\Phi$ angle. Each $\Theta$ angle and the each $\Phi$ angle in the antenna polarization direction is served as one test point.

S30, the ERPs of all test points according to step S20 are composed into the transmission power intensity and direction pattern of the antenna of the terminal and the same is stored. For further increasing the testing accuracy, the ERPs at some test points in the direction pattern may be sampled and tested according to the obtained transmission power intensity and direction pattern, and the transmission power intensity and direction pattern is corrected by using a difference value from an original ERP to form a new transmission power intensity and direction pattern. To be more specific, a test point with the best ERP is found for each $\Theta$ angle of the rotary table, representing $ERP_{ori}$. The $\Phi$ angle and the antenna polarization direction corresponding to the test point is found out, and then the rotary table is rotated to the corresponding antenna polarization direction of the $\Theta$ angle and $\Phi$ angle, and the ERP is re-testied, representing $ERP_{new}$. The difference value between the $ERP_{new}$ and the $ERP_{ori}$ is calculated by a formula offset = $ERP_{new}$ - $ERP_{ori}$. The ERP in the antenna polarization direction of the $\Theta$ angle and $\Phi$ angle is re-corrected by a correction formula $ERP_{new,phi,polar}$= $ERP_{ori,phi,polar}$+ offset, thereby obtaining the optimized ERP at the test point, representing $ERP_{new,phi,polar}$, where $ERP_{ori,phi,polar}$ represents the original ERP in the antenna polarization direction in the transmission power intensity and direction pattern in the $\Theta$ angle and the $\Phi$ angle. A new transmission power intensity and direction pattern is obtained by repeating above steps for other $\Theta$ angles. In this way, the transmission power intensity and direction pattern can be optimized, thereby increasing the testing accuracy.

S40, an antenna polarization direction with the best $\Theta$ angle and the $\Phi$ angle is found out according to the transmission power intensity and direction pattern of the antenna of the terminal. The rotary table in the chamber is rotated to the antenna polarization direction of the $\Theta$ angle and the $\Phi$ angle for testing the ERPs of all channels to be tested, and then the ERP is compensated with a path loss of the chamber so as to serve as the ERP with best $\Theta$ angle and the $\Phi$ angle in the channel to be tested in the antenna polarization direction, representing $ERP_{best,CHi}$. The CHi of the $ERP_{best,\,CHi}$ represents all of the channels to be tested.

S50, the ERP in each channel to be tested of each $\Theta$ angle and each $\Phi$ angle represents an $ERP_{CHi}$, which is calculated by a formula $ERP_{CHi}=ERP+(ERP_{best,CHi}-ERP_{best})$, where $ERP_{best}$ is the transmitted power at best test point in the channel to be tested of the transmission power intensity and direction pattern, ERP is an ERP in an antenna polarization direction of the $\Theta$ angle and the $\Phi$ angle of the rotary table in a current channel to be tested of the transmission power intensity and direction pattern. An integral calculation is executed to obtain TRP of the antenna of the terminal according to a formula $\displaystyle TRP_{CHi} \cong \frac{\pi}{2NM} \sum_{i=0}^{N-1} \sum_{j=0}^{M-1} [ERP_{\theta,CH_i}(\theta_i,\varphi_j) + ERP_{\varphi,CH_i}(\theta_i,\varphi_j)]\sin(\theta_i)$, where

N is the number of test points of the $\Theta$ angle of the rotary table, the $\Phi$ angle is from 0 to 180 degrees, each 30 degrees is one step, and there are 6 steps. Therefore, the number of the test points of the $\Theta$ angle is 6. Similarly, M is the number of test points of the $\Phi$ angle of the rotary table, the $\Phi$ angle is from 0 to 360 degrees, each 30 degrees is one step, and there are 12 steps, and the number of the test points is 12.

For the above steps, since the transmission power intensity and direction pattern is stored while the first testing in step of S30, the steps of S20 and S30 can be omitted when re-testing instead of by using a transmission power intensity and direction pattern. In this way, the testing efficiency can be increased by the method of the present invention, and the searching time of each angle can be decreased.

It should be noted that the above descriptions are merely preferable embodiments of the present invention, but are not intended to limit the scope of the present invention. Those of ordinary skill in the art can make increases, decreases, replacements, variations, or improvements according to the above description without departing from the spirit and principle of the present invention, and all of the increases, decreases, replacements, variations, and improvements should be contained within the scope of the attached claims of the present invention.

**Claims**

1.  A method for quickly testing a total radiated power of an antenna of a terminal, comprising:

    looking up a first antenna polarization direction from a pre-stored transmission power intensity and direction pattern, wherein the first antenna polarization direction corresponds to a $\Theta$ angle and a $\Phi$ angle which conform with a prescribed requirement;

    rotating a rotary table to a direction corresponding to the first antenna polarization direction;

    measuring equivalent radiated powers of all channels to be tested in the first antenna polarization direction;

    compensating the equivalent radiated power with a path loss of a chamber, thereby obtaining $ERP_{best,CHi}$;

    calculating $ERP_{CHi}$ according to a formula $ERP_{CHi}=ERP+(ERP_{best,CHi}-ERP_{best})$, wherein the $ERP_{CHi}$ is the equivalent radiated power of each channel to be tested, the $ERP_{best}$ is a transmitted power at a test point which conforms with the prescribed requirement in the transmission power intensity and direction pattern, the ERP is an equivalent radiated power of the channel to be tested in a current antenna polarization direction; and

    integral calculating and obtaining $TRP_{CHi}$ according to a formula $TRP_{CHi}$

$$TRP_{CHi} \cong \frac{\pi}{2NM} \sum_{i=0}^{N-1} \sum_{j=0}^{M-1} [ERP_{\theta,CH_i}(\theta_i,\varphi_j) + ERP_{\varphi,CH_i}(\theta_i,\varphi_j)] \sin(\theta_i)$$

, wherein N is a number of test points corresponding to the $\Theta$ angle, M is a number of test points corresponding to the $\Phi$ angle, i and j are integer numbers;

    wherein a working channel is set at a middle value of all channels to be tested, the antenna polarization direction comprises a horizontal polarization direction and a perpendicular polarization direction.

2.  The method for quickly testing the total radiated power of the antenna of the terminal according to claim 1, further comprising:

    composing the equivalent radiated powers of all test points into the transmission power intensity and direction pattern and storing the same, wherein each $\Theta$ angle and each $\Phi$ angle corresponding to the antenna polarization direction is served as one of the test points.

3.  The method for quickly testing the total radiated power of the antenna of the terminal according to claim 2, further comprising:

    rotating the terminal either to the $\Theta$ angle or the $\Phi$ angle by rotating the rotary table; and

    testing the equivalent radiated power at each of the test points, wherein the equivalent radiated power of the test point corresponds to power of the test point in one channel, and a rotation to either the $\Theta$ angle or the $\Phi$ angle corresponds to a variation of the antenna polarization direction.

4.  The method for quickly testing the total radiated power of the antenna of the terminal according to claim 3, further comprising:

    transmitting a signal emitted from a base station emulator to the terminal by a measuring antenna in the chamber, wherein the terminal is disposed upon the rotary table in the chamber, and the terminal is connected with the base station emulator by the antenna; and

    setting any one of the channels to be tested as the working channel of the base station emulator.

5.  The method for quickly testing the total radiated power of the antenna of the terminal according to claim 1, further comprising:

    sampling and testing the equivalent radiated power of the test point according to the transmission power intensity and direction pattern; and

    correcting the transmission power intensity and direction pattern by using a difference value from an original equivalent radiated power.

6.  The method for quickly testing the total radiated power of the antenna of the terminal according to claim 5, further comprising:

finding a test point with a best equivalent radiated power $ERP_{ori}$ for each $\Theta$ angle;

looking up a $\Phi$ angle and an antenna polarization direction corresponding to the $ERP_{ori}$, and then rotating to the corresponding antenna polarization direction;

testing an equivalent radiated power $ERP_{new}$;

calculating the difference value between the $ERP_{new}$ and the $ERP_{ori}$ by a formula offset= $ERP_{new}$ - $ERP_{ori}$;

re-correcting the equivalent radiated power by a correction formula $ERP_{new,phi,polar}=ERP_{ori,phi,polar}+offset$, thereby obtaining the optimized equivalent radiated power $ERP_{new,phi,polar}$ of the test point, wherein the $ERP_{ori,phi,polar}$ represents the original equivalent radiated power in the antenna polarization direction corresponding to the $\Theta$ angle and the $\Phi$ angle in the transmission power intensity and direction pattern; and

correcting the transmission power intensity and direction pattern by repeating above steps for other $\Theta$ angles.

7. The method for quickly testing the total radiated power of the antenna of the terminal according to claim 1, wherein a range of the $\Theta$ angle is between 0 and 180 degrees, each 30 degrees is one step, and there are 6 steps.

8. The method for quickly testing the total radiated power of the antenna of the terminal according to claim 1, wherein a range of the $\Phi$ angle is between 0 and 360 degrees, each 30 degrees is one step, and there are 12 steps.

9. A method for quickly testing a total radiated power of an antenna of a terminal, comprising:

looking up a first antenna polarization direction from a pre-stored transmission power intensity and direction pattern, wherein the first antenna polarization direction corresponds to a $\Theta$ angle and a $\Phi$ angle which conform with a prescribed requirement;

rotating a rotary table to a direction corresponding to the first antenna polarization direction;

measuring equivalent radiated powers of all channels to be tested in the first antenna polarization direction;

compensating the equivalent radiated power with a path loss of a chamber, thereby obtaining $ERP_{best,CHi}$;

calculating $ERP_{CHi}$ according to a formula $ERP_{CHi}=ERP+(ERP_{best,CHi}-ERP_{best})$, wherein the $ERP_{CHi}$ is the equivalent radiated power of each channel to be tested, the $ERP_{best}$ is a transmitted power at a test point which conforms with the prescribed requirement in the transmission power intensity and direction pattern, the ERP is an equivalent radiated power of the channel to be tested in a current antenna polarization direction; and

integral calculating and obtaining $TRP_{CHi}$ according to a formula $TRP_{CHi}$

$$\cong \frac{\pi}{2NM}\sum_{i=0}^{N-1}\sum_{j=0}^{M-1}[ERP_{\theta,CH_i}(\theta_i,\varphi_j)+ERP_{\varphi,CH_i}(\theta_i,\varphi_j)]\sin(\theta_i) \;,$$ wherein N is a number of test points corresponding to the $\Theta$ angle, M is a number of test points corresponding to the $\Phi$ angle, i and j are integer numbers.

10. The method for quickly testing the total radiated power of the antenna of the terminal according to claim 9, further comprising:

composing the equivalent radiated powers of all test points into the transmission power intensity and direction pattern and storing the same, wherein each $\Theta$ angle and each $\Phi$ angle corresponding to the antenna polarization direction is served as one of the test points.

11. The method for quickly testing the total radiated power of the antenna of the terminal according to claim 10, further comprising:

rotating the terminal either to the $\Theta$ angle or the $\Phi$ angle by rotating the rotary table; and

testing the equivalent radiated power at each of the test points, wherein the equivalent radiated power of the test point corresponds to power of the test point in one channel, and a rotation to either the $\Theta$ angle or the $\Phi$ angle corresponds to a variation of the antenna polarization direction.

12. The method for quickly testing the total radiated power of the antenna of the terminal according to claim 11, further comprising:

transmitting a signal emitted from a base station emulator to the terminal by a measuring antenna in the chamber, wherein the terminal is disposed upon the rotary table in the chamber, and the terminal is connected with the base station emulator by the antenna; and
setting any one of the channels to be tested as the working channel of the base station emulator.

13. The method for quickly testing the total radiated power of the antenna of the terminal according to claim 9, wherein a working channel is set at a middle value of all channels to be tested.

14. The method for quickly testing the total radiated power of the antenna of the terminal according to claim 9, wherein the antenna polarization direction comprises a horizontal polarization direction and a perpendicular polarization direction.

15. The method for quickly testing the total radiated power of the antenna of the terminal according to claim 9, further comprising:

sampling and testing the equivalent radiated power of the test point according to the transmission power intensity and direction pattern; and
correcting the transmission power intensity and direction pattern by using a difference value from an original equivalent radiated power.

16. The method for quickly testing the total radiated power of the antenna of the terminal according to claim 15, further comprising:

finding a test point with a best equivalent radiated power $ERP_{ori}$ for each $\Theta$ angle;
looking up a $\Phi$ angle and an antenna polarization direction corresponding to the $ERP_{ori}$, and then rotating to the corresponding antenna polarization direction;
testing an equivalent radiated power $ERP_{new}$;
calculating the difference value between the $ERP_{new}$ and the $ERP_{ori}$ by a formula offset= $ERP_{new}$ - $ERP_{ori}$;
re-correcting the equivalent radiated power by a correction formula $ERP_{new,phi,polar}$=$ERP_{ori,phi,polar}$+offset, thereby obtaining the optimized equivalent radiated power $ERP_{new,phi,polar}$ of the test point, wherein the $ERP_{ori,phi,polar}$ represents the original equivalent radiated power in the antenna polarization direction corresponding to the $\Theta$ angle and the $\Phi$ angle in the transmission power intensity and direction pattern; and
correcting the transmission power intensity and direction pattern by repeating above steps for other $\Theta$ angles.

17. The method for quickly testing the total radiated power of the antenna of the terminal according to claim 9, wherein a range of the $\Theta$ angle is between 0 and 180 degrees, each 30 degrees is one step, and there are 6 steps.

18. The method for quickly testing the total radiated power of the antenna of the terminal according to claim 9, wherein a range of the $\Phi$ angle is between 0 and 360 degrees, each 30 degrees is one step, and there are 12 steps.

# INTERNATIONAL SEARCH REPORT

| International application No. |
| --- |
| **PCT/CN2013/082194** |

**A. CLASSIFICATION OF SUBJECT MATTER**

G01R 29/10 (2006.01) i

According to International Patent Classification (IPC) or to both national classification and IPC

**B. FIELDS SEARCHED**

Minimum documentation searched (classification system followed by classification symbols)

IPC: G01R, H04B, H04W, H04Q

Documentation searched other than minimum documentation to the extent that such documents are included in the fields searched

Electronic data base consulted during the international search (name of data base and, where practicable, search terms used)

CNPAT, WPI, EPODOC, CNKI, GOOGLE: BAI, Jian; TCL mobile, hand station or portable equipment, radio frequency, antenna polarization direction, polarity, active test, test point or monitoring point or probe point or measuring point, compensate or correct, terminal or device or equipment or handset or MS or (mobile 1w station), radio or eradiate or radialization or radiate or radiation or radiancy, monitor or measure or test or meter or detect or inspect, (over w the w air), or OTA or (anechoic 1w chamber), point or position or location or station or spot or station or direction or orientation, polarization or polarize

**C. DOCUMENTS CONSIDERED TO BE RELEVANT**

| Category* | Citation of document, with indication, where appropriate, of the relevant passages | Relevant to claim No. |
| --- | --- | --- |
| PX | CN 103257282 A (HUIZHOU TCL MOBILE COMMUNICATION CO., LTD.), 21 August 2013 (21.08.2013), description, pages 3-4 | 1-18 |
| A | CN 101582725 A (ZTE CORP.), 18 November 2009 (18.11.2009), the whole document | 1-18 |
| A | US 20110133999 A1 (ELECTRONICS AND TELECOMMUNICATIONSRESEARCH INSTITUTE), 09 June 2011 (09.06.2011), the whole document | 1-18 |
| A | LIU, Zheng et al., Mobile Handset Antenna Performance Testing Based on the 3D Measurement System, ELECTRONIC SCIENCE AND TECHNOLOGY, June 2009, 2009, vol.22, no.6, pages 55-56, and ISSN 1007-7820 | 1-18 |

☐ Further documents are listed in the continuation of Box C. ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 15 January 2014 (15.01.2014) | **20 February 2014 (20.02.2014)** |

| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer **NING, Bo** Telephone No.: (86-10) **62413288** |
| --- | --- |

Form PCT/ISA/210 (second sheet) (July 2009)

## INTERNATIONAL SEARCH REPORT
Information on patent family members

International application No.

**PCT/CN2013/082194**

| Patent Documents referred in the Report | Publication Date | Patent Family | Publication Date |
|---|---|---|---|
| CN 103257282 A | 21.08.2013 | None | |
| CN 101582725 A | 18.11.2009 | WO 2009137979 A1 | 19.11.2009 |
| | | EP 2285154 A1 | 16.02.2011 |
| | | US 2011095950 A1 | 28.04.2011 |
| US 20110133999 A1 | 09.06.2011 | KR 20110063159 A | 10.06.2011 |

Form PCT/ISA/210 (patent family annex) (July 2009)